# EUROPEAN PATENT SPECIFICATION

(11) **EP 3 428 241 B1**
(45) Date of publication and mention of the grant of the patent: **04.01.2023**
(21) Application number: 18173836.0
(22) Date of filing: 23.05.2018
(51) Int. Cl.: C09J 7/10

(54) **STRETCH RELEASE ADHESIVE, BATTERY ASSEMBLY AND HOUSING ASSEMBLY**
STRETCH-RELEASE-KLEBEBAND, BATTERIEANORDNUNG UND GEHÄUSEANORDNUNG
ADHÉSIF À DÉCOLLEMENT PAR ÉTIREMENT, ENSEMBLE DE BATTERIE ET ENSEMBLE DE BOÎTIER

(30) Priority: 14.07.2017 CN 201710576504; 14.07.2017 CN 201720862418 U
(43) Date of publication of application: 16.01.2019
(73) Proprietor: GUANGDONG OPPO MOBILE TELECOMMUNICATIONS CORP., LTD., Wusha, Chang'an Dongguan, Guangdong 523860 (CN)
(72) Inventor: ZENG, Yuanqing, Dongguan, Guangdong (CN)
(74) Representative: Mewburn Ellis LLP

(56) References cited:
- EP-A1- 2 977 419
- EP-A2- 1 077 242
- WO-A1-2014/209622
- WO-A2-2006/026189
- CN-A- 105 524 570

## Description

### FIELD

The present disclosure relates to a technical field of communication devices, and more particularly, to a stretch release adhesive, a battery assembly and a housing assembly.

### BACKGROUND

In the related art, a stretch release adhesive for bonding a battery assembly in an electronic device adopts a double-sided fully coated adhesive tape. When the adhesive tape is bonded to a surface of a medium (e.g. a battery), there will be air bubbles left between the adhesive tape and the medium, resulting in decrease of an effective bonding area. However, when the stretch release adhesive is torn away, an adhesive surface of the stretch release adhesive in positions of the air bubbles still comes in contact with the battery or the like, which leads to a relatively large pull force and causes the stretch release adhesive to be torn apart easily.

WO2014209622A1 relates to an article including a release liner with an adhesive layer disposed thereon, the adhesive layer including a plurality of stripes of a first pressure-sensitive adhesive and of a second pressure-sensitive adhesive, arranged in a generally alternating pattern. The first pressure-sensitive adhesive is a silicone-based pressure-sensitive adhesive that includes a silicone block copolymer elastomer comprising hard segments that each comprise at least one polar moiety, and the second pressure-sensitive adhesive is an organic polymeric pressure-sensitive adhesive.

WO2006026189A2 relates to methods of making adhesive articles providing air egress by supplying a route for the air to flow out from under the construction. One method includes providing a release liner comprising a moldable layer having a release surface and a back surface; applying a first pattern of a first non-adhesive material to a first portion of the release surface; applying a second pattern of a second non-adhesive material to a second portion of the release surface, wherein the second pattern partially overlaps the first pattern; embedding at least one of the first or second non-adhesive materials into the moldable layer; and transferring an adhesive layer having a front and back surface and end edges onto the release liner, wherein the front surface of the adhesive layer is adhered to the release surface of the release liner.

EP2977419A1 provides a PSA sheet that allows prevention or reduction of damage such as fracture with efficient stretch removability A stretchable PSA sheet is provided, comprising a PSA layer and a film-like substrate supporting the PSA layer. The PSA sheet has a long section. The long section has a tapered segment that extends, tapering to a first end of the length direction and the film-like substrate has a minimum cross-sectional area larger than 0.30 mm 2 in the tapered segment.

EP1077242A2 relates to an adhesive strip which can be peeled off and have a tab at one end against the adhesive zone which extends as far as the other end of the strip. The adhesive zone isdivided into sub-zones in succession from the tab to the far end. The sub-zone next to the tab has a larger cross section surface area than its neighboring sub-zone which, in turn, has a larger cross section surface area than the third sub-zone. The third sub-zone forms the far end of the adhesive strip, with one or more points to the far end. The adhesive sub-zones have adhesion on one or both sides with identical structures on both sides. The cross section surface area of the second sub-zone, from the end of the first sub-zone, is tapered along ≥ 60% of an adhesive strip length and especially ≥ 75% from ≤ 50% of the strip width and especially ≤ 35% compared with the cross section surface area of the first sub-zone. The adhesive strip is thinner in the second and third sub-zones than at the first sub-zone, and especially 20% thinner to the end of the strip and especially in a continuous thickness reduction. The third sub-zone has a number of points with an angle between the strips of ≤ 35 degrees and especially ≤ 20 degrees . The total strip length is ≥ 20 mm and especially 25-100 mm. The width of the first sub-zone is 8-30 mm and especially 10-25 mm. The peeling force at the first adhesive sub-zone is ≥ 5 N and especially ≥ 10 N. The peeling force at the second adhesive sub-zone is considerably less than for the first zone and the catapult force on release of the third adhesive sub-zone is ≤ 0.1 N.

CN105524570A provides an adhesive tap component and a binding product, which belong to the technical field of pull-to-remove adhesive tapes and solve the problem that the existing pull-to-remove adhesive tape is easily broken when being removed at a large pulling angle. The adhesive tape component is used for being bound on at least one base and comprises a pull-to-remove adhesive tape and an intermediate layer, wherein the pull-to-remove adhesive tape has a binding surface; the intermediate layer covers at least part of the bonding surface of the pull-to-remove adhesive tape and has a first surface and a second surface opposite to each other; the first surface is used for binding with the base; the second surface is bound on the binding surface and at least part of the second surface directly contacts with the binding surface. The second surface has a Ra value between 0.1mu m to 7mu m.

### SUMMARY

The present disclosure aims to solve at least one of the technical problems existing in the related art. Accordingly, the present disclosure provides a stretch release adhesive that can reduce friction between the stretch release adhesive and articles.

The present disclosure further provides a battery assembly, and the battery assembly includes the above stretch release adhesive.

The present invention is defined in the independent claim 1, and optional features of the present invention are defined in the dependent claims.

The present disclosure further provides a housing assembly for an electronic device, and the housing assembly includes the above battery assembly.

The stretch release adhesive according to embodiments of the present disclosure includes: a first adhesive layer having viscidity; and a second adhesive layer having viscidity, the second adhesive layer and the first adhesive layer being superposed, and the second adhesive layer including a plurality of first adhesive portions spaced apart from one another.

For the stretch release adhesive according to embodiments of the present disclosure, by providing the second adhesive layer superposed on the first adhesive layer and making the second adhesive layer include the plurality of spaced first adhesive portions, not only a gap between the two adjacent first adhesive portions can be used to lower a pull force required to tear the stretch release adhesive, thereby making it easily attainable to remove or tear the stretch release adhesive, and preventing redundant adhesive from being affixed to a surface of the article being bonded, but also the air between the first adhesive portion and the article being bonded can be discharged from the gap during the bonding, so as to reduce internal air bubbles and enable the bonding to be more secure, thereby saving production costs without affecting the adhesive function of the stretch release adhesive.

According to some embodiments of the present disclosure, the first adhesive portion exhibits a strip shape.

According to some embodiments of the present disclosure, the first adhesive portion extends along a straight line or a curve.

According to some embodiments of the present disclosure, the plurality of first adhesive portions are parallel.

According to some embodiments of the present disclosure, the plurality of first adhesive portions are evenly spaced apart.

According to some embodiments of the present disclosure, each of the first adhesive portions has the same width.

According to some embodiments of the present disclosure, the width of the first adhesive portion is gradually decreased or gradually increased in a direction from an end of the first adhesive portion to the other end of the first adhesive portion.

According to some embodiments of the present disclosure, the first adhesive layer comprises a plurality of second adhesive portions spaced apart.

According to some embodiments of the present disclosure, a third adhesive layer is provided, the third adhesive layer and the first adhesive layer are superposed, and the third adhesive layer is located at a side of the first adhesive layer away from the second adhesive layer.

According to some embodiments of the present disclosure, a gap existing between two adjacent first adhesive portions constitutes an adhesive-free zone of the second adhesive layer and the adhesive-free zone is filled with non-adhesive filler.

The battery assembly according to embodiments of the present disclosure includes: a battery compartment, a groove being defined in the battery compartment; a battery provided in the groove; and the above stretch release adhesive, the stretch release adhesive being provided between an inner wall of the groove and the battery.

For the battery assembly according to embodiments of the present disclosure, by providing the second adhesive layer superposed on the first adhesive layer and making the second adhesive layer include the plurality of spaced first adhesive portions, not only the gap between the two adjacent first adhesive portions can be used to lower the pull force required to tear the stretch release adhesive, thereby making it easily attainable to remove or tear the stretch release adhesive, and preventing redundant adhesive from being affixed to the surface of the article being bonded, but also the air between the first adhesive portion and the article being bonded can be discharged from the gap during the bonding, so as to reduce the internal air bubbles and enable the bonding to be more secure, thereby saving production costs without affecting the adhesive function of the stretch release adhesive.

According to some embodiments of the present disclosure, the second adhesive layer is bonded with the battery, while the first adhesive layer is bonded with the inner wall of the groove.

According to some embodiments of the present disclosure, an extension direction of the first adhesive portion forms an angle β with an assembly/disassembly direction of the battery, and the angle β satisfies 0°≤β<90°.

The housing assembly according to embodiments of the present disclosure includes the above battery assembly.

For the housing assembly according to embodiments of the present disclosure, by providing the second adhesive layer superposed on the first adhesive layer and making the second adhesive layer include the plurality of spaced first adhesive portions, not only the gap between the two adjacent first adhesive portions can be used to lower the pull force required to tear the stretch release adhesive, thereby making it easily attainable to remove or tear the stretch release adhesive, and preventing redundant adhesive from being affixed to the surface of the article being bonded, but also the air between the first adhesive portion and the article being bonded can be discharged from the gap during the bonding, so as to reduce the internal air bubbles and enable the bonding to be more secure, thereby saving production costs without affecting the adhesive function of the stretch release adhesive.

According to some embodiments of the present disclosure, the housing assembly is made of magnesium alloy.

### BRIEF DESCRIPTION OF THE DRAWINGS

These and additional aspects and advantages of embodiments of the present disclosure will become apparent and more readily appreciated from the following descriptions made with reference to the drawings, in which:
Fig. 1 is a view illustrating an effect after cutting a stretch release adhesive according to an embodiment of the present disclosure.
Fig. 2 illustrates a front view of a stretch release adhesive according to an embodiment of the present disclosure.
Fig. 3 illustrates a bottom view of a stretch release adhesive according to an embodiment of the present disclosure.
Fig. 4 illustrates a front view of a battery assembly according to an embodiment of the present disclosure.
Fig. 5 is a view illustrating an internal structure of a battery assembly according to an embodiment of the present disclosure.
Fig. 6 is a view illustrating structures of a stretch release adhesive and a battery according to an embodiment of the present disclosure.
Fig. 7 is a schematic view of an electronic device according to an embodiment of the present disclosure.

Reference numerals:
electronic device 1,
housing assembly 10,
battery assembly 100, battery compartment 110, groove 111, battery 120,
stretch release adhesive 130, first adhesive layer 131, second adhesive layer 132, first adhesive portion 133.

### DETAILED DESCRIPTION

Embodiments of the present disclosure will be described in detail and examples of the embodiments will be illustrated in the accompanying drawing. The same or similar elements and the elements having same or similar functions are denoted by like reference numerals throughout the descriptions. The embodiments described herein with reference to the drawings are explanatory, which aim to illustrate the present disclosure, but shall not be construed to limit the present disclosure.

In the specification, it is to be understood that terms such as "central," "longitudinal," "lateral," "length," "width," "thickness," "upper," "lower," "front," "rear," "left," "right," "vertical," "horizontal," "top," "bottom," "inner," "outer," "clockwise," "counterclockwise," "axial," "radial," and "circumferential" should be construed to refer to the orientation or position as then described or as illustrated in the drawings under discussion. These relative terms are for convenience of description, and do not indicate or imply that the device or element referred to must have a particular orientation or be constructed and operated in a particular orientation, and hence cannot be constructed to limit the present disclosure. In addition, the feature defined with "first" and "second" may indicate or imply including one or more of this feature. In the description of the present disclosure, the term "a plurality of' means two or more than two, unless specified otherwise.

In the description of the present disclosure, it should be understood that, unless specified or limited otherwise, the terms "mounted," "connected," and "coupled" and variations thereof are used broadly, and may be, for example, fixed connections, detachable connections, or integral connections; may also be mechanical or electrical connections; may also be direct connections or indirect connections via intervening structures; may also be inner communications of two elements, which can be understood by those skilled in the art according to specific situations.

The present disclosure provides a stretch release adhesive.

The stretch release adhesive according to embodiments of the present disclosure includes: a first adhesive layer having viscidity; and a second adhesive layer having viscidity, the second adhesive layer and the first adhesive layer being superposed, and the second adhesive layer including a plurality of first adhesive portions spaced apart from one another.

The battery assembly according to embodiments of the present disclosure includes: a battery compartment, a groove being defined in the battery compartment; a battery provided in the groove; and the above stretch release adhesive, the stretch release adhesive being provided between an inner wall of the groove and the battery.

The housing assembly according to embodiments of the present disclosure includes the above battery assembly.

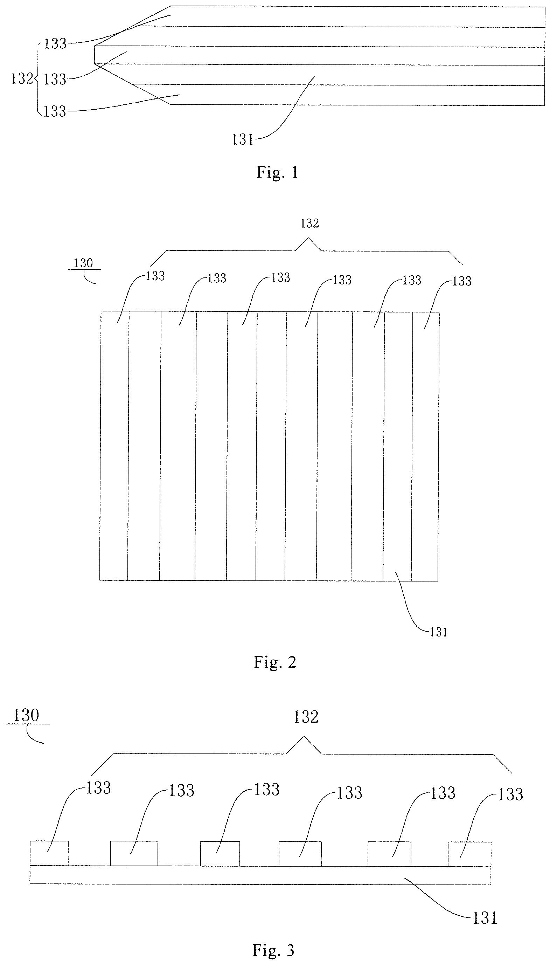

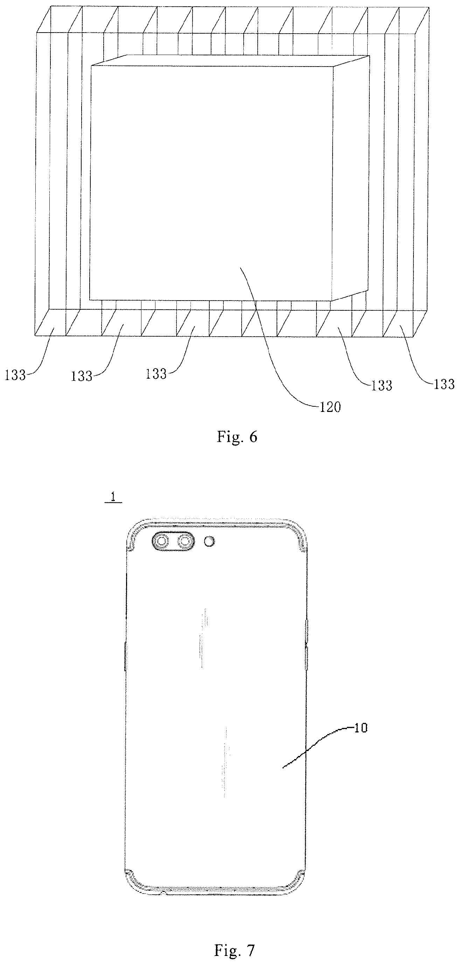

A stretch release adhesive 130 according to embodiments of the present disclosure will be described below with reference to Figs. 1-7.

As illustrated in Figs. 1-3, the stretch release adhesive 130 according to embodiments of the present disclosure includes a first adhesive layer 131 and a second adhesive layer 132.

Specifically, as illustrated in Figs. 1-3, the first adhesive layer 131 has viscidity, the second adhesive layer 132 also has viscidity, and the second adhesive layer 132 and the first adhesive layer 131 are superposed. The second adhesive layer 132 includes a plurality of first adhesive portions 133 spaced apart. The plurality of first adhesive portions 133 is directly stuck on the first adhesive layer 131, and a gap exists among the plurality of first adhesive portions 133.

It could be understood that the second adhesive layer 132 has an adhesive zone and an adhesive-free zone, the first adhesive portion 133 is the adhesive zone on the first adhesive layer 131 while the gap between two adjacent first adhesive portions 133 is the adhesive-free zone, and different bonding requirements can be satisfied by reasonably setting the proportion of the adhesive zones to the adhesive-free zones. When larger bonding strength is required, an area of the adhesive zones can be increased relatively, i.e. increasing the area of the first adhesive portions 133; when smaller bonding strength is required, the area of the adhesive zones can be decreased relatively.

Additionally, since the second adhesive layer includes the plurality of spaced first adhesive portions 133, the air bubbles produced when the stretch release adhesive 130 is bonded to an article can be discharged through the gap between the two adjacent first adhesive portions 133, thereby reducing internal air bubbles to avoid a phenomenon of no contact in a relatively large scale even at the presence of adhesive.

Moreover, due to the presence of the gap between the two adjacent first adhesive portions 133, i.e. due to the presence of the adhesive-free zone, the bonding strength between the second adhesive layer 132 and the article can be reduced, and when the stretch release adhesive 130 is torn away from the article, frictional resistance can be reduced, to facilitate removal of the stretch release adhesive 130 from the article.

For the stretch release adhesive 130 according to embodiments of the present disclosure, by providing the second adhesive layer 132 superposed on the first adhesive layer 131 and making the second adhesive layer 132 include the plurality of spaced first adhesive portions 133, not only the gap between the two adjacent first adhesive portions 133 can be used to lower a pull force required to tear the stretch release adhesive 130, thereby making it easily attainable to remove or tear the stretch release adhesive 130, and preventing redundant adhesive from being affixed to the surface of the article being bonded, but also the air between the first adhesive portion 133 and the article being bonded can be discharged from the gap during the bonding, so as to reduce the internal air bubbles and enable the bonding to be more secure, thereby saving production costs without affecting the adhesive function of the stretch release adhesive 130.

In some embodiments, as illustrated in Figs. 1 and 2, the first adhesive portion 133 can exhibit a strip shape, and for example, the first adhesive portion 133 can be a rectangular strip, an oval strip, a zigzag strip or the like. Thus, an acting force between the first adhesive portion 133 and the object to be bonded can be made more uniform. It should be noted that the shapes of the plurality of first adhesive portions 133 can be identical or can be different. For example, in an embodiment of the present disclosure, as illustrated in Fig. 2, the plurality of first adhesive portions 133 are in the rectangular strip, and the length-to-width ratio of the plurality of first adhesive portions 133 can be different or can be the same.

Furthermore, the first adhesive portion 133 can extend along a straight line or a curve. Thus, in the case of ensuring reliable bonding of the stretch release adhesive 130, the structural diversity of the stretch release adhesive 130 can be increased to meet the needs of different users. For instance, in the example shown in Figs. 1 and 2, the first adhesive portion 133 extends along the straight line. Certainly, the present disclosure is not limited thereto, and the first adhesive portion 133 can also extend along the curve, such as a wavy line and a zigzag line.

In some embodiments of the present disclosure, as illustrated in Figs. 1-3, the plurality of first adhesive portions 133 are parallel. Hence, the structure and manufacturing procedure of the second adhesive layer 132 and thus of the stretch release adhesive 130 are simplified, so as to shorten a production cycle and reduce the production costs.

In some embodiments of the present disclosure, as illustrated in Figs. 1-3, the plurality of first adhesive portions 133 are evenly spaced apart, that is, the sizes of the gaps between the two adjacent first adhesive portions 133 are identical. Hence, the structure and manufacturing procedure of the second adhesive layer 132 and thus of the stretch release adhesive 130 are simplified, so as to shorten the production cycle and reduce the production costs.

In some embodiments of the present disclosure, as illustrated in Figs. 1-3, the plurality of first adhesive portions 133 have the same width. Hence, the structure and manufacturing procedure of the second adhesive layer 132 and thus of the stretch release adhesive 130 are simplified, so as to shorten the production cycle and reduce the production costs.

In some embodiments of the present disclosure, in a direction from an end of the first adhesive portion 133 to the other end of the first adhesive portion 133, the width of the first adhesive portion 133 is gradually decreased or gradually increased, so as to improve the structural diversity of the first adhesive portion 133. For example, when the stretch release adhesive 130 is bonded to the article, the width of the first adhesive portion 133 can be gradually enlarged in a direction of removal of the article.

In some embodiments of the present disclosure, the first adhesive layer 131 can include a plurality of second adhesive portions spaced apart, and the second adhesive portion extends in the same direction as the first adhesive portion 133. In a direction perpendicular to the first adhesive layer 131, the first adhesive portion 133 is opposite to the second adhesive portion, and the width of the first adhesive portion 133 is not equal to the width of the second adhesive portion. For example, in the direction perpendicular to the first adhesive layer 131, the first adhesive portion 133 is opposite to the second adhesive portion, and the width of the first adhesive portion 133 is smaller than that of the second adhesive portion; or in the direction perpendicular to the first adhesive layer 131, the first adhesive portion 133 is opposite to the second adhesive portion, and the width of the first adhesive portion 133 is greater than that of the second adhesive portion. Thus, on the premise of ensuring reliable bonding of the first adhesive portion 133 and the second adhesive portion, the material cost of the first adhesive layer 131 can be saved.

In some embodiments of the present disclosure, the first adhesive layer 131 include the plurality of spaced second adhesive portions, and the extension direction of the second adhesive portion is at an angle α to the extension direction of the first adhesive portion 133, in which α satisfies 0°<a≤90°. Thus, on the premise of ensuring reliable bonding of the first adhesive portion 133 and the second adhesive portion, the cost of the first adhesive layer 131 is saved. For example, the angle α between the first adhesive portion 133 and the second adhesive portion can be 90°, that is, the first adhesive portion 133 is perpendicular to the second adhesive portion.

In some embodiments of the present disclosure, a third adhesive layer is provided. The third adhesive layer and the first adhesive layer 131 are superposed, the third adhesive layer is located at a side of the first adhesive layer 131 away from the second adhesive layer 132, and the third adhesive layer includes a plurality of third adhesive portions spaced apart from one another. Thus, when the first adhesive layer 131 is bonded to the article, it is possible to be bonded to the article through the third adhesive layer, such that not only a gap between two adjacent third adhesive portions can be utilized to reduce the pull force required to tear the stretch release adhesive 130, thereby making it easily attainable to remove or tear the stretch release adhesive 130, and preventing redundant adhesive from being affixed to the surface of the article being bonded, but also the air between the third adhesive portion and the article being bonded can be discharged from the gap during the bonding, so as to reduce the internal air bubbles and enable the bonding to be more secure.

A battery assembly 100 according to embodiments of the present disclosure will be described below with reference to Figs. 1-7.

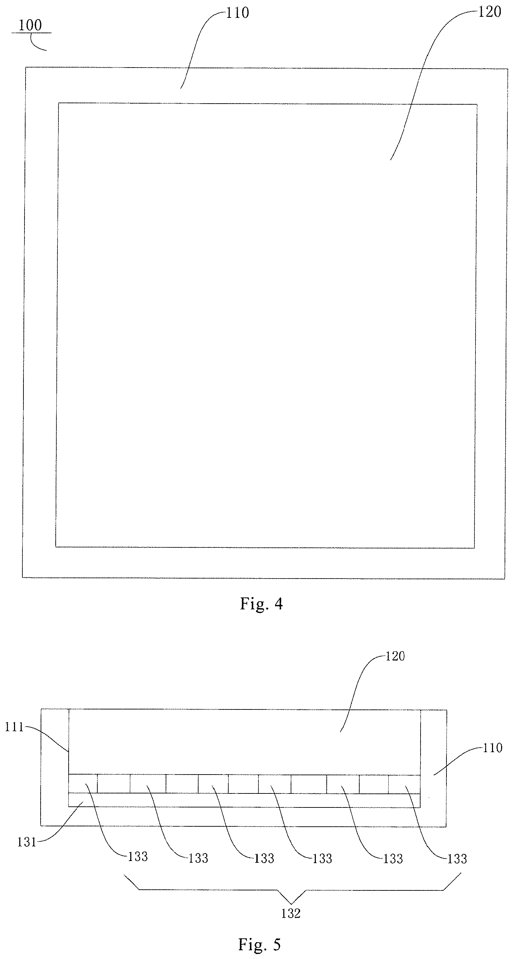

As illustrated in Figs. 4-6, the battery assembly 100 according to embodiments of the present disclosure includes a battery compartment 110, a battery 120 and the above stretch release adhesive 130.

Specifically, a groove 111 is defined in the battery compartment 110, the battery 120 is disposed in the groove 111, and the stretch release adhesive 130 is disposed between an inner wall of the groove 111 and the battery 120 to fasten the battery 120 in the groove 111 of the battery compartment 110. The first adhesive layer 131 of the stretch release adhesive 130 can be bonded with one of the inner wall of the groove 111 and a surface of the battery 120, while the second adhesive layer 132 can be bonded with the other of the inner wall of the groove 111 and the surface of the battery 120.

For the battery assembly 100 according to embodiments of the present disclosure, by providing the second adhesive layer 132 superposed on the first adhesive layer 131 and making the second adhesive layer 132 include the plurality of spaced first adhesive portions 133, not only the gap between the two adjacent first adhesive portions 133 can be used to lower the pull force required to tear the stretch release adhesive 130, thereby making it easily attainable to remove or tear the stretch release adhesive 130, and preventing redundant adhesive from being affixed to the surface of the article being bonded, but also the air between the first adhesive portion 133 and the article being bonded can be discharged from the gap during the bonding, so as to reduce the internal air bubbles and enable the bonding to be more secure, thereby saving production costs without affecting the adhesive function of the stretch release adhesive 130.

In some embodiments of the present disclosure, as illustrated in Fig. 5, the first adhesive layer 131 is bonded with the inner wall of the groove 111, and the second adhesive layer 132 is bonded with the battery 120. Thus, it is possible to reduce the friction between the surface of the battery 120 and the stretch release adhesive 130, thereby facilitating the disassembly of the battery 120, and discharge the air between the first adhesive portion 133 and the article being bonded through the gap, thereby reducing the internal air bubbles and making the bonding more secure. For instance, in an example illustrated by Fig. 5, the first adhesive layer 131 is bonded with an inner bottom wall of the groove 111, and the second adhesive layer 132 is bonded with a lower surface of the battery 120.

In some embodiments of the present disclosure, the extension direction of the first adhesive portion 133 is at an angle β to an assembly/disassembly direction of the battery 120, in which β satisfies 0°≤β<90°. Thus, it is possible to ensure that in the disassembly direction of the battery 120, the first adhesive portion 133 keeps contact with the surface of the battery 120, thereby avoiding intermittent vibration of the battery 120 during the disassembly, so as to guarantee continuity of the disassembly process of the battery 120. Additionally, it is possible to prevent the first adhesive portion 133 from being torn apart in the disassembly process of the battery 120.

Further, the extension direction of the first adhesive portion 133 is identical to the assembly/disassembly direction of the battery 120. Thus, not only the continuity of the disassembly process of the battery 120 can be guaranteed, but also the first adhesive portion 133 can be further prevented from being torn apart in the disassembly process of the battery 120, thereby making the disassembly of the battery 120 from the groove 111 more convenient and easier.

In some embodiments of the present disclosure, the battery compartment 110 can be a magnesium alloy piece or an aluminum alloy piece. It could be understood that the material for manufacturing the battery compartment 110 can be a magnesium alloy or an aluminum alloy. The magnesium alloy and the aluminum alloy both have advantages of high strength and light texture, and are not easy to deform, thereby being suitable as a production material of the battery compartment 110.

A housing assembly 10 for an electronic device 1 according to embodiments of the present disclosure will be described below with reference to Figs. 1-7. The housing assembly 10 for the electronic device 1 according to embodiments of the present disclosure includes the above battery assembly 100.

In some embodiments of the present disclosure, the battery compartment 110 is defined by the housing assembly 10. The housing assembly 10 can be a magnesium alloy piece or an aluminum alloy piece.

For the housing assembly 10 of the electronic device 1 according to embodiments of the present disclosure, by providing the second adhesive layer 132 superposed on the first adhesive layer 131 and making the second adhesive layer 132 include the plurality of spaced first adhesive portions 133, not only the gap between the two adjacent first adhesive portions 133 can be used to lower the pull force required to tear the stretch release adhesive 130, thereby making it easily attainable to remove or tear the stretch release adhesive 130, and preventing redundant adhesive from being affixed to the surface of the article being bonded, but also the air between the first adhesive portion 133 and the article being bonded can be discharged from the gap during the bonding, so as to reduce the internal air bubbles and enable the bonding to be more secure, thereby saving production costs without affecting the adhesive function of the stretch release adhesive 130.

The electronic device 1 according to embodiments of the present disclosure will be described below with reference to Figs. 1-7.

The electronic device 1 according to embodiments of the present disclosure includes the above housing assembly 10.

For the electronic device 1 according to embodiments of the present disclosure, by providing the second adhesive layer 132 superposed on the first adhesive layer 131 and making the second adhesive layer 132 include the plurality of spaced first adhesive portions 133, not only the gap between the two adjacent first adhesive portions 133 can be used to lower the pull force required to tear the stretch release adhesive 130, thereby making it easily attainable to remove or tear the stretch release adhesive 130, and preventing redundant adhesive from being affixed to the surface of the article being bonded, but also the air between the first adhesive portion 133 and the article being bonded can be discharged from the gap during the bonding, so as to reduce the internal air bubbles and enable the bonding to be more secure, thereby saving production costs without affecting the adhesive function of the stretch release adhesive 130.

The electronic device 1 according to a specific embodiment of the present disclosure will be described in detail with reference to Figs. 1-7. It could be understood that the following description is only exemplary illustration rather than a specific limitation on present disclosure.

In the embodiments of the present disclosure, the electronic device 1 can be various devices capable of acquiring data from the outside and processing the data, or the electronic device 1 can be any device that has a built-in battery 120 and is capable of receiving current from the outside to charge the battery 120, such as a mobile phone, a tablet computer, a computing device or an information display device.

The mobile phone is taken as an example to introduce the electronic device 1 to which the present disclosure is applicable. The mobile phone can include an ultrasonic chip, a radio frequency circuit, a memory, an input unit, a wireless fidelity (Wi-Fi) module, a display unit, a sensor, an audio circuit, a processor, a projection unit, a photographing unit 103, a battery 120, and a stretch release adhesive 130, a housing assembly 10, and other components.

Specifically, as illustrated in Figs. 1-7, the electronic device 1 includes the housing assembly 10, the battery compartment 110 is defined in the housing assembly 10, the battery compartment 110 has the groove 111, the battery 120 is disposed in the groove 111, and the battery 120 is coupled with the bottom wall of the groove 111 by means of the stretch release adhesive 130.

The stretch release adhesive 130 includes the first adhesive layer 131 and the second adhesive layer 132, and both of the first adhesive layer 131 and the second adhesive layer 132 have viscidity. The first adhesive layer 131 is a conventional adhesive layer, i.e. a common adhesive layer, and the first adhesive layer 131 is a monolithic adhesive layer. The second adhesive layer 132 and the first adhesive layer 131 are superposed, and the second adhesive layer 132 includes a plurality of first adhesive portions 133 evenly spaced apart. Each first adhesive portion exhibits a rectangular strip structure, extends along the straight line, and has the same width, and the plurality of first adhesive portions 133 is disposed parallel. When the stretch release adhesive 130 is wound into a roll shape, the first adhesive portion 133 extends along a length direction of the stretch release adhesive 130. The second adhesive layer 132 has the adhesive zone and the adhesive-free zone, the first adhesive portion 133 constitutes the adhesive zone of the second adhesive layer 132, and the gap existing between two adjacent first adhesive portions 133 constitutes the adhesive-free zone of the second adhesive layer 132. The adhesive zone and the adhesive-free zone are arranged in a staggered manner.

As illustrated in Fig. 5, the first adhesive layer 131 is bonded with the bottom wall of the groove 111, while the first adhesive portion 133 of the second adhesive layer 132 is bonded with the surface of the battery 120 opposite to the bottom wall of the groove 111. The extension direction of the first adhesive portion 133 is identical to the disassembly direction of the battery 120.

In a process of manufacturing the stretch release adhesive 130, first, an entire adhesive face is cut to remove an unwanted part of the adhesive face (release paper is not cut), then the second adhesive layer 132 is formed with showing an effect of spaced strips, and another adhesive face (the first adhesive layer 131) and the adhesive face with the effect of spaced strips are fully bonded together and are subjected to die-cutting to achieve a desired effect, so as to obtain the stretch release adhesive 130 of the present disclosure. Certainly, the place where the adhesive face is cut off can be filled with non-adhesive filler.

The stretch release adhesive 130 of the present disclosure can reduce the internal air bubbles and maintain relatively equally effective adhesion with the same tape width. Additionally, if this adhesive structure is used as the stretch release adhesive 130, it is possible to reduce an area of a contact surface with the medium on a side of the stretch release adhesive 130 with spaced strips during the disassembly of the battery 120 bonded with the stretch release adhesive 130 (that is, there is an adhesive-free zone compared with a full adhesive surface, i.e. there is a certain ratio of the adhesive-free area to the adhesive area). By utilizing the ratio of the adhesive-free area to the adhesive area, the contact surface between the actual adhesive surface and the battery 120 is decreased when the stretch release adhesive 130 is pulled, so as to reduce the pull force and facilitate the disassembly.

The display unit can be embedded in a front side of the electronic device 1 and coupled with the housing. The display unit can be configured to display information input by or presented to the user, and various menus of the mobile phone. The display unit can include a display panel, and optionally, the display panel can be configured in forms of a liquid crystal display (LCD), an organic light-emitting diode (OLED) and the like. Further, the touch panel can overlay the display panel; when the touch panel detects a touch operation on or near it, the touch operation is sent to the processor to determine which type the touch event belongs to, and then the processor provides corresponding visual output on the display panel according to the type of the touch event. The location, which can be recognized by the user's eye in the display panel, besides the visual output, can serve as a "display area" described later. The touch panel and the display panel can be two separate components to achieve input and output functions of the mobile phone, or can be integrated to achieve the input and output functions of the mobile phone.

The radio-frequency (RF) circuit can be used to receive and transmit a signal during information transmission and reception or during a call. Especially, when downlink information from a base station is received, the RF circuit sends the downlink information to the processor for processing, and additionally sends uplink data from the mobile phone to the base station. Usually, the RF circuit includes but is not limited to an antenna, at least one amplifier, a transceiver, a coupler, a low-noise amplifier, a duplexer and etc. In addition, the RF circuit can communicate with the network and other devices via wireless communication. The wireless communication can employ any communication standard or protocol, including but not limited to global system for mobile communication (GSM), general packet radio service (GPRS), code division multiple access (CDMA), wideband code division multiple access (WCDMA), long term evolution (LTE), e-mail and short messaging service (SMS).

The memory can be used to store software programs and modules, and the processor runs various software applications in the mobile phone and performs data processing by running the software programs and modules stored in the memory. The memory can mainly include a program storage area and a data storage area. The program storage area can store an operating system, at least one application program required for a function (such as a voice playback function, an image playback function and etc.); the data storage area can store data (such as audio data, contacts and etc.) created according to the use of the mobile phone. In addition, the memory can include a high-speed random access memory, and can also include a non-volatile memory, such as at least one disk storage device and flash memory device, or include other volatile solid state memory devices.

The input unit can be configured to receive incoming numbers or character information, and generate a key signal related to user settings and function control of the mobile phone. Specifically, the input unit can include a touch panel and other input devices. The touch panel, also known as a touch screen, can collect a touch operation made by a user on or near the touch panel (for example, an operation made by the user on the touch panel or near the touch panel by means of a finger, a touch pen or any other suitable object or accessory), and drive the corresponding connection device according to a preset program. Optionally, the touch panel can include a touch detection device and a touch controller. The touch detection device is configured to detect a touch orientation of the user, detect a signal from the touch operation, and transmit the signal to the touch controller. The touch controller is configured to receive the touch signal from the touch detection device, convert it into contact coordinates and send the contact coordinates to the processor, and can be configured to receive and execute a command from the processor. In addition, it is possible to realize the touch panel in resistive type, capacitive type, infrared type, surface acoustic wave type and other types. The input unit can include other input devices apart from the touch panel. Specifically, other input devices can include, but are not limited to one or more of a physical keypad, a function key (e.g. a volume control button, an on/off button, etc.), a trackball, a mouse and an operating rod.

In addition, the mobile phone can also include at least one sensor, such as an attitude sensor, a light sensor and other sensors.

Specifically, the attitude sensor can also be referred as a motion sensor, and as one kind of motion sensor, a gravity sensor can be employed. As for the gravity sensor, a cantilever displacement device is made of an elastic-sensitive element, and an electrical contact is driven by an energy-storage spring made of the elastic-sensitive element, so as to achieve the conversion of gravity changes into electrical signal changes.

As an alternative motion sensor, an accelerometer sensor can be used. The accelerometer sensor can detect the magnitude of acceleration in all directions (generally in three axes), and detect the magnitude and direction of the gravity at rest, and can be used for attitude identification of the mobile phone (such as horizontal and vertical screen switch, related games, magnetometer attitude calibration), and vibration-recognition related functions (such as pedometer and percussion).

In the embodiments of the present disclosure, the motion sensors listed above can be used as an element for obtaining an "attitude parameter" described later, which is not limited thereto, however. Other sensors capable of obtaining the "attitude parameter" fall into the protection scope of the present disclosure, for example, a gyroscope. The working principle and data processing of the gyroscope can be similar to the related art, so the detailed description thereof will be omitted to avoid redundancy.

In addition, in the embodiments of the present disclosure, a barometer, a hygrometer, a thermometer, an infrared sensor and the like can be used as a sensor, which will not be described in detail.

The light sensor can include an ambient light sensor and a proximity sensor, in which the ambient light sensor can adjust brightness of the display panel in accordance with the ambient light, and the proximity sensor can turn off the display panel and/or backlight when the mobile phone is moved to the ear.

The audio circuit, the loudspeaker and the microphone can provide an audio interface between the user and the mobile phone. The audio circuit can transmit an electrical signal converted from the received audio data to the loudspeaker, and the loudspeaker converts the electrical signal into an audio signal to be output. On the other hand, the microphone converts the collected audio signal into the electrical signal, and the audio circuit receives and converts the electrical signal into audio data, and transmits the audio data to the processor. After processed by the processor, the audio data is sent to, for example, another mobile phone via the RF circuit, or is output to the memory for further processing.

Wi-Fi is a short distance wireless transmission technology, and the mobile phone can help the user send and receive e-mails, browse websites, and access streaming media through the Wi-Fi module which provides the user with wireless broadband access to the Internet.

The processor is a control center of the mobile phone, is connected to various parts of the mobile phone by means a variety of interfaces and lines, and performs various functions of the mobile phone and data processing by running or executing software programs and/or modules stored in the memory and by invoking the data stored in the memory, so as to monitor the mobile phone overall. Optionally, the processor can include one or more processing units; preferably, the processor can be integrated with an application processor and a modem processor, in which the application processor mainly handles the operating system, the user interface and the application program, while the modem processor mainly deals with wireless communication.

It could be understood that the modem processor may not be integrated into the processor.

Moreover, the processor can act as an implementing element of the processing unit, to perform the same or similar function as the processing unit.

It should be noted that the mobile phone is only an example of the electronic device 1 and is not constructed to limit the present disclosure. The present disclosure can be applied to the electronic device 1 such as a mobile phone, a tablet computer and so on, and the present disclosure is not limited thereto.

## Claims

1. A stretch release adhesive (130), comprising:
a first adhesive layer (131) having viscidity; and
a second adhesive layer (132) having viscidity, the second adhesive layer (132) and the first adhesive layer (131) being superposed, and the second adhesive layer (132) comprising a plurality of first adhesive portions (133) spaced apart from one another,
wherein in a direction perpendicular to a plane where the first adhesive layer (131) and the second adhesive layer (132) contact, the first adhesive layer (131) and the second adhesive layer (132) are located in different planes, a gap exists between adjacent first adhesive portions (133),
**characterized in that** the plurality of first adhesive portions (133) are directly stuck on the first adhesive layer (131).

2. The stretch release adhesive (130) according to claim 1, wherein the first adhesive portion (133) exhibits a strip shape.

3. The stretch release adhesive (130) according to claim 1 or 2, wherein the first adhesive portion (133) extends along a straight line or a curve.

4. The stretch release adhesive (130) according to any one of claims 1 to 3, wherein the plurality of first adhesive portions (133) are parallel.

5. The stretch release adhesive (130) according to any one of claims 1 to 4, wherein the plurality of first adhesive portions (133) are evenly spaced apart.

6. The stretch release adhesive (130) according to any one of claims 1 to 5, wherein each of the first adhesive portions (133) has the same width.

7. The stretch release adhesive (130) according to any one of claims 1 to 6, wherein the width of the first adhesive portion (133) is gradually decreased or gradually increased in a direction from an end of the first adhesive portion (133) to the other end of the first adhesive portion (133).

8. The stretch release adhesive (130) according to any one of claims 1 to 7, wherein the first adhesive layer (131) comprises a plurality of second adhesive portions spaced apart.

9. The stretch release adhesive (130) according to any one of claims 1 to 8, wherein a third adhesive layer is provided, the third adhesive layer and the first adhesive layer (131) are superposed, and the third adhesive layer is located at a side of the first adhesive layer (131) away from the second adhesive layer (132).

10. The stretch release adhesive (130) according to any one of claims 1 to 9, wherein the gap existing between two adjacent first adhesive portions (133) constitutes an adhesive-free zone of the second adhesive layer (132) and the adhesive-free zone is filled with non-adhesive filler.

11. A battery assembly (100), comprising:
a battery compartment (110), a groove (111) being defined in the battery compartment (110);
a battery (120) provided in the groove (111); and
a stretch release adhesive (130) according to any one of claims 1 to 10, the stretch release adhesive (130) being provided between an inner wall of the groove (111) and the battery (120).

12. The battery assembly (100) according to claim 11, wherein the first adhesive layer (131) is bonded with the inner wall of the groove (111), while the second adhesive layer (132) is bonded with the battery (120).

13. The battery assembly (100) according to claim 11 or 12, wherein an extension direction of the first adhesive portion (133) forms an angle β with an assembly/disassembly direction of the battery (120), and the angle β satisfies 0°≤β< 90°.

14. A housing assembly (10) for an electronic device (1), comprising a battery assembly (100) according to any one of claims 11 to 13.

15. The housing assembly (10) for the electronic device (1) according to claim 14, wherein the housing assembly (10) is made of magnesium alloy.

## Patentansprüche

1. Durch Dehnung ablösbares Haftmittel (130), das Folgendes umfasst:
eine erste Haftschicht (131), die Klebrigkeit aufweist; und
eine zweite Haftschicht (132), die Klebrigkeit aufweist, wobei die zweite Haftschicht (132) und die erste Haftschicht (131) übereinandergelegt sind und wobei die zweite Haftschicht (132) mehrere erste Haftabschnitte (133) umfasst, die voneinander beanstandet sind, wobei sich die erste Haftschicht (131) und die zweite Haftschicht (132) in einer Richtung senkrecht zu einer Ebene, in der sich die erste Haftschicht (131) und die zweite Haftschicht (132) berühren, in unterschiedlichen Ebenen befinden, wobei zwischen benachbarten ersten Haftabschnitten (133) ein Zwischenraum vorhanden ist,
**dadurch gekennzeichnet, dass** die mehreren ersten Haftabschnitte (133) direkt an der ersten Haftschicht (131) kleben.

2. Durch Dehnung ablösbares Haftmittel (130) nach Anspruch 1, wobei der erste Haftabschnitt (133) eine Streifenform zeigt.

3. Durch Dehnung ablösbares Haftmittel (130) nach Anspruch 1 oder 2, wobei der erste Haftabschnitt (133) entlang einer Geraden oder einer Kurve verläuft.

4. Durch Dehnung ablösbares Haftmittel (130) nach einem der Ansprüche 1 bis 3, wobei die mehreren ersten Haftabschnitte (133) parallel sind.

5. Durch Dehnung ablösbares Haftmittel (130) nach einem der Ansprüche 1 bis 4, wobei die mehreren ersten Haftabschnitte (133) gleichmäßig beanstandet sind.

6. Durch Dehnung ablösbares Haftmittel (130) nach einem der Ansprüche 1 bis 5, wobei jeder der ersten Haftabschnitte (133) dieselbe Breite aufweist.

7. Durch Dehnung ablösbares Haftmittel (130) nach einem der Ansprüche 1 bis 6, wobei die Breite des ersten Haftabschnitts (133) in einer Richtung von einem Ende des ersten Haftabschnitts (133) zu dem anderen Ende des ersten Haftabschnitts (133) allmählich verringert oder allmählich vergrößert ist.

8. Durch Dehnung ablösbares Haftmittel (130) nach einem der Ansprüche 1 bis 7, wobei die erste Haftschicht (131) mehrere zweite Haftabschnitte umfasst, die beanstandet sind.

9. Durch Dehnung ablösbares Haftmittel (130) nach einem der Ansprüche 1 bis 8, wobei eine dritte Haftschicht vorgesehen ist, wobei die dritte Haftschicht und die erste Haftschicht (131) übereinandergelegt sind und wobei sich die dritte Haftschicht auf einer Seite der ersten Haftschicht (131), die von der zweiten Haftschicht (132) entfernt ist, befindet.

10. Durch Dehnung ablösbares Haftmittel (130) nach einem der Ansprüche 1 bis 9, wobei der Zwischenraum, der zwischen zwei benachbarten ersten Haftabschnitten (133) vorhanden ist, eine haftmittelfreie Zone der zweiten Haftschicht (132) bildet und wobei die haftmittelfreie Zone mit einem nichtklebenden Füllstoff gefüllt ist.

11. Batterieanordnung (100), die Folgendes umfasst:
ein Batteriefach (110), eine Vertiefung (111), die in dem Batteriefach (110) definiert ist;
eine Batterie (120), die in der Vertiefung (111) vorgesehen ist; und
ein durch Dehnung ablösbares Haftmittel (130) nach einem der Ansprüche 1 bis 10, wobei das durch Dehnung ablösbare Haftmittel (130) zwischen einer Innenwand der Vertiefung (111) und der Batterie (120) vorgesehen ist.

12. Batterieanordnung (100) nach Anspruch 11, wobei die erste Haftschicht (131) mit der Innenwand der Vertiefung (111) verbunden ist, während die zweite Haftschicht (132) mit der Batterie (120) verbunden ist.

13. Batterieanordnung (100) nach Anspruch 11 oder 12, wobei eine Verlaufsrichtung des ersten Haftabschnitts (133) mit einer Einbau-/Ausbaurichtung der Batterie (120) einen Winkel β bildet und wobei der Winkel β 0° ≤ β < 90° erfüllt.

14. Gehäuseanordnung (10) für eine elektronische Vorrichtung (1), die eine Batterieanordnung (100) nach einem der Ansprüche 11 bis 13 umfasst.

15. Gehäuseanordnung (10) für eine elektronische Vorrichtung (1) nach Anspruch 14, wobei die Gehäuseanordnung (10) aus einer Magnesiumlegierung hergestellt ist.

## Revendications

1. Adhésif à décollement par étirement (130), comprenant :
une première couche adhésive (131) dotée de viscosité ; et
une deuxième couche adhésive (132) dotée de viscosité, la deuxième couche adhésive (132) et la première couche adhésive (131) étant superposées, et la deuxième couche adhésive (132) comprenant une pluralité de premières parties adhésives (133) espacées entre elles,
dans une direction perpendiculaire à un plan où la première couche adhésive (131) et la deuxième couche adhésive (132) viennent en contact, la première couche adhésive (131) et la deuxième couche adhésive (132) occupant des plans différents, un espace existant entre des premières parties adhésives (133) adjacentes,
**caractérisé en ce que** la pluralité de premières parties adhésives (133) sont directement collées sur la première couche adhésive (131).

2. Adhésif à décollement par étirement (130) selon la revendication 1, dans lequel la première partie adhésive (133) présente la forme d'une bande.

3. Adhésif à décollement par étirement (130) selon la revendication 1 ou 2, dans lequel la première partie adhésive (133) s'étend suivant une ligne droite ou une courbe.

4. Adhésif à décollement par étirement (130) selon l'une quelconque des revendications 1 à 3, dans lequel la pluralité de premières parties adhésives (133) sont parallèles.

5. Adhésif à décollement par étirement (130) selon l'une quelconque des revendications 1 à 4, dans lequel la pluralité de premières parties adhésives (133) sont régulièrement espacées.

6. Adhésif à décollement par étirement (130) selon l'une quelconque des revendications 1 à 5, dans lequel chacune des premières parties adhésives (133) est pourvue de la même largeur.

7. Adhésif à décollement par étirement (130) selon l'une quelconque des revendications 1 à 6, dans lequel la largeur de la première partie adhésive (133) diminue progressivement ou augmente progressivement dans une direction allant d'une extrémité de la première partie adhésive (133) à l'autre extrémité de la première partie adhésive (133).

8. Adhésif à décollement par étirement (130) selon l'une quelconque des revendications 1 à 7, dans lequel la première couche adhésive (131) comprend une pluralité de deuxièmes parties adhésives espacées.

9. Adhésif à décollement par étirement (130) selon l'une quelconque des revendications 1 à 8, dans lequel une troisième couche adhésive est fournie, la troisième couche adhésive et la première couche adhésive (131) sont superposées, et la troisième couche adhésive se situe d'un côté de la première couche adhésive (131) opposé à la deuxième couche adhésive (132).

10. Adhésif à décollement par étirement (130) selon l'une quelconque des revendications 1 à 9, dans lequel l'espace existant entre deux premières parties adhésives (133) adjacentes constitue une zone dépourvue d'adhésif de la deuxième couche adhésive (132) et la zone dépourvue d'adhésif est garnie d'une garniture non adhésive.

11. Ensemble batterie (100), comprenant :
un compartiment (110) de batterie, une rainure (111) étant définie dans le compartiment (110) de batterie ;
une batterie (120) placée dans la rainure (111) ; et
un adhésif à décollement par étirement (130) selon l'une quelconque des revendications 1 à 10, l'adhésif à décollement par étirement (130) étant placé entre une paroi intérieure de la rainure (111) et la batterie (120) .

12. Ensemble batterie (100) selon la revendication 11, dans lequel la première couche adhésive (131) adhère à la paroi intérieure de la rainure (111) tandis que la deuxième couche adhésive (132) adhère à la batterie (120) .

13. Ensemble batterie (100) selon la revendication 11 ou 12, dans lequel une direction d'étendue de la première partie adhésive (133) forme un angle β avec une direction de montage/démontage de la batterie (120), et l'angle β vérifie 0°≤β<90°.

14. Ensemble boîtier (10) pour un dispositif électronique (1), comprenant un ensemble batterie (100) selon l'une quelconque des revendications 11 à 13.

15. Ensemble boîtier (10) pour le dispositif électronique (1) selon la revendication 14, l'ensemble boîtier (10) étant en alliage de magnésium.
